# FASCICULE DE BREVET EUROPEEN

(11) **EP 0 284 067 B1**
(45) Date de publication et mention de la délivrance du brevet: **02.03.1994**
(21) Numéro de dépôt: 88104740.1
(22) Date de dépôt: 24.03.1988
(51) Int. Cl.: G01R 31/02

(54) **Identificateur de phases**
Phasenidentifizierer
Identifier for phases

(30) Priorité: 27.03.1987 CA 533170
(43) Date de publication de la demande: 28.09.1988
(73) Titulaire: HYDRO-QUEBEC, Montréal Québec H2Z 1A4 (CA)
(72) Inventeur: Bouchard, Bertrand, Laval Québec H7M 1Y5 (CA)
(74) Mandataire: Casalonga, Axel

(56) Documents cités:
- DE-C- 540 082
- US-A- 2 789 268
- US-A- 4 491 785
- PATENT ABSTRACTS OF JAPAN vol. 7, no. 278 (P-242)(1423) 10 décembre 1983, & JP-A-58 155371 (MITSUBISHI) 16 septembre 1983,

## Description

La présente invention a trait à un système et à une méthode d'identification des conducteurs de phases de circuits électriques reliés électriquement ensemble avec ou sans mise à la terre, de tous les conducteurs selon le choix de l'utilisateur en amont de l'endroit choisi pour l'identification, à l'aide de deux générateurs indépendants de signaux audio-différents reliés par couplage électromagnétique auxdits conducteurs de phases à un endroit accessible le long de ces conducteurs, et d'un moyen de réception approprié desdits signaux audio-différents reliés auxdits conducteurs de phases à l'endroit choisi pour l'identification.

Jusqu'à présent, les identificateurs de conducteurs de phases en usage constitués principalement d'identificateurs à output (boîtier de résistances, diodes, générateurs de signaux audio ou pulsatifs) sont reliés directement ou indirectement aux conducteurs de phases à identifier et ne peuvent pas fonctionner en présence de mise à la terre en amont de l'endroit de l'identification desdits conducteurs. Ceci nécessite le retrait de ces mises à la terre durant la période d'identification, ce qui cause un problème sérieux au niveau de la sécurité des identificateurs. De plus, il est nécessaire de brancher un signal de détection directement sur les conducteurs. Un tel système est, par exemple, décrit dans le brevet américain numéro 2,789,268 émis le 16 avril 1957.

L'une des caractéristiques de la présente invention consiste donc dans la réalisation et la mise au point d'un système et d'une méthode d'identification des conducteurs de phases de circuits électriques, en présence ou non de la mise à la terre de tous les conducteurs de phases en amont de l'endroit choisi pour l'identification et sans contact direct aux conducteurs.

Une deuxième caractéristique de la présente invention consiste en la mise au point d'un système d'identification de conducteurs de phases qui consiste en deux générateurs indépendants de signaux audio-différents transmis aux conducteurs de phases par couplage électromagnétique.

Une autre caractéristique de la présente invention consiste en la réalisation d'un système pour l'identification des conducteurs de phases de circuits électriques dans lequel les deux générateurs indépendents de signaux audio différents sont couplés électromagnétiquement à des conducteurs de phases, et ce à n'importe lequel endroit accessible le long du câble.

Une autre caractérisque de la présente invention consiste en ce que les générateurs de signaux audio sont à piles rechargeables et ont l'apparence de pinces ampèremétriques.

Une autre caractérisque de la présente invention consiste en ce que l'identification des conducteurs de phases du circuit électrique, à l'endroit choisi pour l'identification, est faite à l'aide de moyens de réceptions appropriés (écouteurs, amplificateurs-haut-parleurs) desdits signaux audio différents émis par les deux générateurs indépendents, lesdits moyens de réception pouvant être reliés à deux des conducteurs de phases à être identifiés soit directement, si les conducteurs de phases sont dénudés, soit par couplage électromagnétique si les conducteurs sont isolés et ne se terminent pas à l'endroit de l'identification.

Une autre caractéristique de la présente invention consiste en la mise au point d'une méthode relativement simple, fiable et sécuritaire pour l'identification de conducteurs de phases de circuits électriques reliés électriquement ensemble avec ou sans mise à la terre de tous les conducteurs de phases, méthode dans laquelle l'identification des conducteurs de phases est réalisée par le raccordement (direct ou électromagntique) du moyen de réception des signaux audio différents aux conducteurs de phases pris deux à deux.

Une autre caractéristique de la présente invention consiste en ce que l'un des générateurs de signaux audio différents émet un signal audio intermittent, et l'autre générateur émet un signal audio continu.

De ce qui précède, et dans son aspect le plus large, la présente invention propose donc un système d'identification de conducteurs de phases relié électriquement ensemble avec ou sans mise à la terre de tous les conducteurs selon le choix de l'utilisateur en amont de l'endroit choisi pour l'identification, à l'aide de deux générateurs indépendents de signaux audio-différents, respectivement reliés par couplage électromagnétique à deux des conducteurs de phases préalablement identifiés d'un circuit électrique donné, à un endroit accessible le long desdits conducteurs de phases situé en amont d'un endroit choisi pour l'identification, et un moyen de réception desdits signaux audio différents reliés auxdits conducteurs de phases pris deux à deux à l'endroit choisi pour l'identification.

La présente invention propose également une méthode d'identification des conducteurs de phases de circuits électriques reliés électriquement ensemble avec ou sans mise à la terre mise à la terre des conducteurs de phases d'un circuit électrique donné, et ce, au moins en amont de l'endroit choisi pour l'identification, qui consiste à installer deux générateurs indépendents de signaux audio différents respectivement reliés par couplage électromagnétique à deux des conducteurs de phases préalablement identifiés dudit circuit électrique à un endroit accessible le long desdits conducteurs de phases, en amont dudit endroit choisi pour l'identification, et à identifier lesdits signaux audio différents raccordés auxdits conducteurs de phases pris deux à deux à l'endroit choisi pour l'identification.

Des réalisations préférées de la présente invention seront maintenant décrite en se référant aux dessins 1 à 4 dans lesquels:
La FIGURE 1 illustre les composantes du système d'identificateur de conducteurs de phases;
La FIGURE 2 illustre l'arrangement des différents constituants d'un câble unipolaire;
La FIGURE 3 illustre schématiquement une méthode d'identification de conducteurs de phases isolés;
La FIGURE 4 illustre schématiquement le moyen d'identifier les conducteurs de phases pris deux à deux (méthode entre phases).

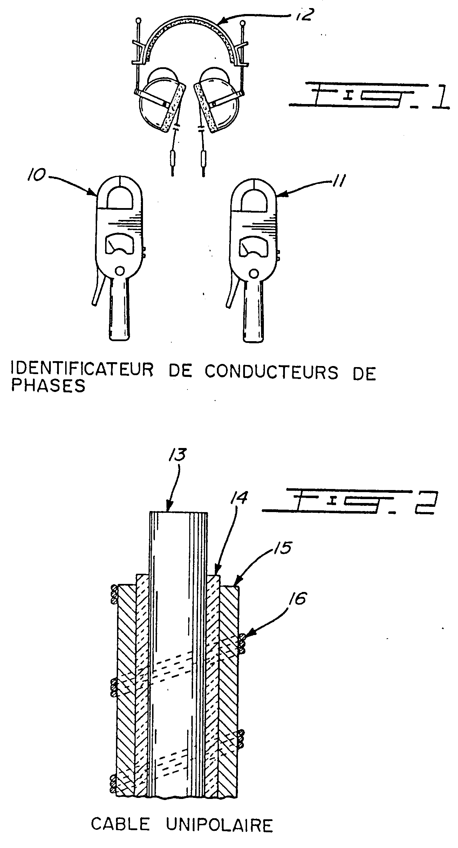

Se référant à la Figure 1, on y voit les principaux constituants du système d'identification des conducteurs de phases d'un circuit électrique comprenant d'une part les deux générateurs indépendents 10 et 11 des signaux audio différents (intermittents et continus) et d'autre part, un moyen de réception 12 desdits signaux audio différents constitué en l'occurence d'une paire d'écouteurs. A noter que ce moyen de réception peut également être constitué d'un amplificateur-haut-parleur.

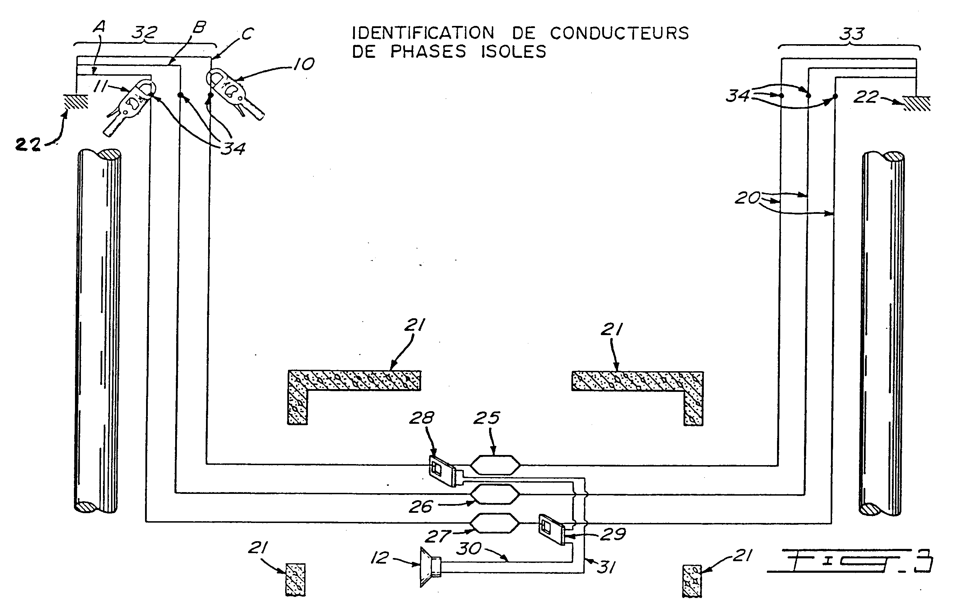

La Figure 2 illustre l'arrangement des différents constituants d'un câble unipolaire constituant généralement l'un des conducteurs de phases d'un circuit électrique. Ce câble unipolaire est généralement constitué d'un noyau conducteur 12 lequel est entouré d'une couche isolante synthétique 14 recouverte d'une gaine semi-conductrice 15 (semi-conducteur) autour de laquelle des fils de cuivre étamé 16 constituent le neutre concentrique. Un circuit électrique est généralement formé d'un ensemble de trois de ces câbles unipolaires. Il pourrait également être constitué d'un seul câble comprenant trois conducteurs de phases appelé câble triphasé.

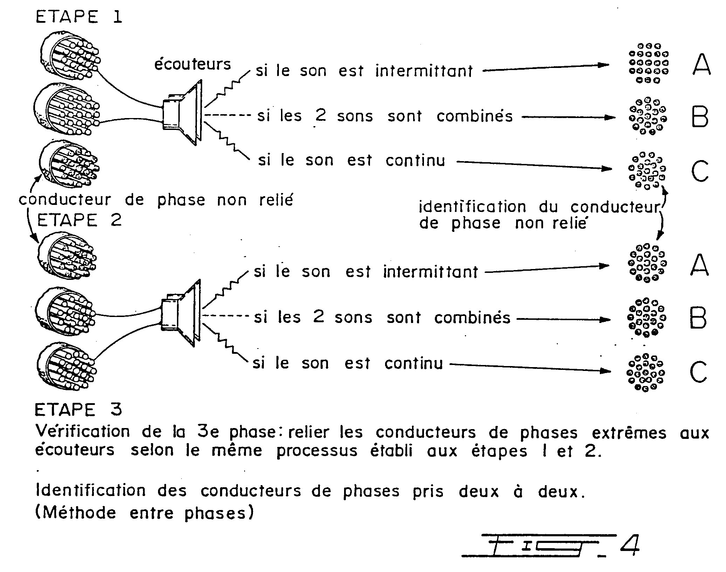

Se référant maintenant aux Figures, et plus particulièrement à la Figure 3, nous allons maintenant décrire une réalisation préférée de la présente invention montrant la mise en application du système d'identification des conducteurs de phases de circuits électriques. D'une façon générale, la Figure 3 illustre un puit d'accès 21 dans lequel passe une section de circuits électriques 20 dont les conducteurs de phases A, B, et C, sont identifiés à l'extrémité 32 de la section 20 située en amont de l'endroit choisi pour l'identification (puit d'accès 21). Aux terminaisons 34 assurant le raccord de la section 20 aux extrémités 32 et 33 du circuit électrique dont les conducteurs de phases à identifier, tous les conducteurs de phases peuvent ou non être mis à la terre (selon le choix de l'utilisateur). A un endroit accessible, le long des conducteurs de phases, on raccorde par couplage électromagnétique le générateur de signal audio continu 11 au conducteur de la phase A et le générateur de signal audio-intermittent 10 au conducteur, le moyen de réception desdits signaux audio différents 12 est relié par les conducteurs 30 et 31 à des pinces réceptrices 28 et 29 assurant un couplage électromagnétique à deux des conducteurs de phases A, B and C (n'importe lesquels). Ces pinces réceptrices 28 et 29 sont placées juste au dessus du semi-conducteur 15, près des raccords isolés 25, 26 et 27, sous le neutre concentrique 16. Il est bien entendu que le couplage électromagnétique à l'aide des pinces réceptrices 28 et 29 n'est pas nécessaire quand présence de conducteurs de phases isolés tel qu'illustré à la Figure 3. Dans le cas de conducteurs de phases dénudés, on peut raccorder directement le moyen de réception 12 aux conducteurs de phases à l'aide des conducteurs 30 et 31. Dans les deux cas on précède alors à l'identification des conducteurs de phases pris deux à deux à l'aide de la méthode entre-phases illustrée à la Figure 4. Dans cette Figure 4, les générateurs de signaux audio différents 10 et 11 ne sont pas illustré. Cependant, puisque par convention, on branche toujours le générateur de signal audio continu à la phase A et le générateur de signal audio intermittent à la phase C, il est bien évident que si dans une première étape on branche le moyen de réception 12 à deux des conducteurs de phases quelconques au moyen des conducteurs 30 et 31, nous aurons réception d'un signal. Si le son est intermittent, cela signifie que les conducteurs 30 et 31 du réception 12 sont branché sur les conducteurs de phase B et C (générateur de signal audio-intermittent), et que le conducteur de phase non relié au récepteur 12 est celui de la phase A. Si par contre le son est continu, cela signifie que le conducteur de phase non relié au récepteur 12 est celui de la phase C. Si par contre les deux sont combinés, cela signifie que le récepteur 12 est branché au conducteur de phase A et C et que le conducteur de phase non branché est celui de la phase B. Cette première étape permet d'identifier un premier conducteur de phase. Dans une seconde étape, l'un des conducteurs 30 ou 31 est branché sur le conducteur de phase qu'on vient d'identifier. Selon la nature du son reçu par le récepteur 12, nous sommes maintenant en mesure d'identifier celui des conducteurs de phases qui n'est pas branché durant cette deuxième étape. L'identification du troisième conducteur de phase est donc réalisé par élimination, et cette identification peut être confirmée par une troisième étape consistant à relier les conducteurs 30 et 31 du récepteur 12 aux deux conducteurs de phases préalablement identifiés.

L'invention offre donc un système et une méthode d'identification des conducteurs de phases de circuits électriques en présence ou non de mise à la terre desdits conducteurs de phases, qui sont à la fois sécuritaires, fiables, flexibles, d'opération et d'installation simple, de faible encombrement, et d'un coût d'achat peu élevé.

Les réalisations de la présente invention seront particulièrement utiles aux équipes de jonction de câbles de distribution souterraines leurs permettant de travailler en toute sécurité sans interruption de mise à la terre, s'il y a lieu, durant l'exécution des travaux de jonction.

La présente invention couvre également toutes les modifications évidentes de réalisations décrites ci-haut en autant que de telles modifications soient couvertes par l'étendue des revendications qui suivent.

## Revendications

1. Un système d'identification de la phase de trois conducteurs électriques de phases (A,B,C), pourvus d'un recouvrement de blindage (15,16), isolés dans un circuit électrique et reliés entre-eux avec ou sans mise à la terre (22) à un endroit (32,33) éloigné de l'endroit choisi pour l'identification de la phase, ledit système étant caractérisé par deux générateurs indépendants (10, 11) de signaux audio-différents respectivement reliés par couplage électromagnétique et sans contact physique à deux des conducteurs de phases (A,B,C) ayant chacun une phase déjà identifiée et à un endroit accessible le long desdits conducteurs de phases situé en amont de l'endroit choisi pour l'identification de la phase, et un moyen de réception pour recevoir lesdits signaux audio-différents par deux pinces réceptrices (28,29) reliées auxdits conducteurs de phases pris deux à deux à l'endroit choisi pour l'identification et produisant des signaux audio afin d'identifier la phase des conducteurs de phases.

2. Un système tel que revendiqué à la revendication 1, dans lequel le circuit électrique est constitué d'un câble triphasé (A,B,C).

3. Un système tel que revendiqué à la revendication 1, dans lequel le circuit électrique est constitué d'un ensemble de trois câbles unipolaires (A,B,C).

4. Un système tel que revendiqué à la revendication 1, dans lequel un des signaux audio est intermittent et l'autre continu.

5. Un système tel que revendiqué dans la revendication 1, dans lequel les deux générateurs (10,11) indépendants de signaux audio-différents sont à piles rechargeables.

6. Un système tel que revendiqué à la revendication 1, dans lequel les deux générateurs (10,11) indépendants de signaux audio-différents ont l'apparence de pinces ampèremétriques.

7. Un système tel que revendiqué à la revendication 1, dans lequel ledit moyen de réception des signaux audio-différents est une simple paire d'écouteurs (12).

8. Un système tel que revendiqué à la revendication 1, dans lequel ledit moyen de réception de signaux audio-différents est un amplificateur-haut-parleur (12).

9. Un système tel que revendiqué à la revendication 1, dans lequel les conducteurs de phases à l'endroit choisi pour l'identification sont des conducteurs dénudés.

10. Un système tel que revendiqué à la revendication 1, dans lequel les conducteurs de phases à l'endroit choisi pour l'identification sont des conducteurs isolés.

11. Un système tel que revendiqué aux revendications 1 ou 9, dans lequel ledit moyen de réception (28,29) est raccordé par couplage électrique direct aux conducteurs de phases à l'endroit choisi pour l'identification.

12. Un système tel que revendiqué aux revendications 1 ou 10, dans lequel ledit moyen de réception est raccordé aux conducteurs de phases à l'endroit choisi pour l'identification, par couplage électromagnétique par l'entremise de pinces réceptrices (28,29).

13. Un système tel que revendiqué à la revendication 1, dans lequel l'endroit choisi pour l'identification est situé dans un puits d'accès (21), près des raccords isolés (25,26,27) des conducteurs de phases du circuit électrique donné.

14. Un système tel que revendiqué à la revendication 1, dans lequel l'endroit choisi pour l'identification est situé aux terminaisons (34) desdits conducteurs de phases dudit circuit électrique donné.

15. Une méthode d'identification de phases de trois conducteurs (A,B,C) électriques de phases ayant un recouvrement blindé (15,16) autour d'un noyau conducteur (13), isolés dans un circuit électrique et reliés entre-eux avec ou sans mise à la terre (22), à un endroit éloigné de l'endroit choisi pour l'identification, ladite méthode étant caractérisée en ce qu'elle consiste à installer deux générateurs (10,11) indépendants de signaux audio-différents respectivement reliés par couplage électromagnétique et sans contact physique avec ledit noyau conducteur à deux des conducteurs (A,B,C) de phases préalablement identifiés dudit circuit électrique, à un endroit le long desdits conducteurs de phases en amont de l'endroit choisi pour l'identification, et à identifier lesdits conducteurs de phases à l'aide d'un moyen de réception accouplé auxdits conducteurs de phases pris deux à deux à l'endroit choisi pour l'identification.

16. Une méthode telle que revendiquée à la revendication 15, dans laquelle le circuit électrique est constitué d'un câble triphasé (A,B,C).

17. Une méthode telle que revendiquée à la revendication 15, dans laquelle le circuit électrique est constitué d'un ensemble de trois câbles unipolaires (A,B,C).

18. Une méthode telle que revendiquée à la revendication 15, dans laquelle l'un des signaux audio est intermittent et l'autre continu.

19. Une méthode telle que revendiquée à la revendication 15, dans laquelle les deux générateurs (10,11) indépendants de signaux audio-différents sont à piles rechargeables.

20. Une méthode telle que revendiquée à la revendication 15, dans laquelle les deux générateurs (10,11) indépendants de signaux audio-différents ont l'apparence de pinces ampèremétriques.

21. Une méthode telle que revendiquée à la revendication 15, dans laquelle ledit moyen de réception des signaux audio-différents est une simple paire d'écouteurs (12).

22. Une méthode telle que revendiquée à la revendication 15, dans laquelle ledit moyen de réception des signaux audio-différents est un amplificateur-haut-parleur (12).

23. Une méthode telle que revendiquée à la revendication 15, dans laquelle lesdits conducteurs de phases à l'endroit choisi pour l'identification sont des conducteurs dénudés.

24. Une méthode telle que revendiquée à la revendication 15, dans laquelle les conducteurs de phases à l'endroit choisi pour l'identification sont des conducteurs isolés.

25. Une méthode telle que revendiquée aux revendications 15 ou 23, dans laquelle ledit moyen de réception (28,29) est raccordé par couplage électrique direct aux conducteurs de phases à l'endroit choisi pour l'identification.

26. Une méthode telle que revendiquée aux revendications 15 ou 24, dans laquelle ledit moyen de réception est raccordé aux conducteurs de phases, à l'endroit choisi pour l'identification, par couplage électromagnétique par l'entremise de pinces réceptrices (28,29).

27. Une méthode telle que revendiquée à la revendication 15, dans laquelle l'endroit choisi pour l'identification est situé dans un puits d'accès (21), près des raccords isolés (25,26,27) des conducteurs de phases dudit circuit électrique donné.

28. Une méthode telle que revendiquée à la revendication 15, dans laquelle l'endroit choisi pour l'identification est situé aux terminaisons (34) desdits conducteurs de phases dudit circuit électrique donné.

29. Une méthode telle que revendiquée aux revendications 17 ou 27, dans laquelle des mises à la terre (21,22) sur chacun des conducteurs de phases (A,B,C) d'un circuit électrique donné sont installées à chacune des extrémités dudit circuit et dans laquelle ledit moyen de réception (28,29) desdits signaux audio-différents est raccordé auxdits conducteurs de phases pris deux à deux à l'endroit choisi pour l'identification, par couplage électromagnétique à l'aide de pinces réceptrices (28,29) placées sur lesdits deux conducteurs de phases dudit circuit électrique donné près des raccords isolés (25,26,27), et par dessus le recouvrement blindé (15,16) desdits deux conducteurs.

## Claims

1. A system for identifying the phase of three electric phase conductors (A, B, C) provided with an armoured covering (15, 16) and insulated in an electric circuit and interconnected, with or without earthing, at a place (32, 33) remote from the place chosen for identifying the phase, the system being characterised by two independent generators (10, 11) of different audio signals and connected by electromagnetic coupling and without physical contact to two of the phase conductors (A, B, C) each having an already-identified phase and at an accessible place along the phase conductors situated upstream of the place chosen for identifying the phase, and a receiving means for receiving the different audio signals via receiver clips 28, 29) connected to the pairs of phase conductors at the place chosen for identification and producing audio signals for identifying the phase of the phase conductors.

2. A system as claimed in claim 1, in which the electric circuit comprises a three-phase cable (A, B, C).

3. A system as claimed in claim 1, in which the electric circuit comprises a set of three unipolar cables (A, B, C).

4. A system as claimed in claim 1, in which one of the audio signals is intermittent and the other is continuous.

5. A system as claimed in claim 1, in which the two independent generators (10, 11) of different audio signals have rechargeable batteries.

6. A system as claimed in claim 1, in which the two independent generators (10, 11) of different audio signals have the appearance of clip-on probes.

7. A system as claimed in claim 1, in which the means for receiving different audio signals is an ordinary pair of earphones (12).

8. A system as claimed in claim 1, in which the means for receiving different audio signals is a public address amplifier (12).

9. A system as claimed in claim 1, in which the phase conductors at the place chosen for identification are bare conductors.

10. A system as claimed in claim 1, in which the phase conductors at the place chosen for identification are insulated conductors.

11. A system as claimed in claim 1 or 9, in which the receiving means (28, 29) is connected by direct electric coupling to the phase conductors at the place chosen for identification.

12. A system as claimed in claim 1 or 10, in which the receiving means is connected to the phase conductors at the place chosen for identification, by electromagnetic coupling via receiver clips (28, 29).

13. A system as claimed in claim 1, in which the place chosen for identification is situated in a manhole (21) near the insulated connections (25, 26, 27) of the phase conductors in the given electric circuit.

14. A system as claimed in claim 1, in which the place chosen for identification is situated at the terminations (34) of the phase conductors in the given electric circuit.

15. A method of identifying the phases of three insulated electric phase conductors (A, B, C) having an armoured covering (15, 16) around a conducting core (13) and insulated in an electric circuit and interconnected, with or without earthing (22), at a place remote from the place chosen for identification, the method being characterised in that it consists in installing two independent generators (10, 11) of different audio signals respectively connected by electromagnetic coupling and without physical contact to the conducting core and to two of the previously-identified phase conductors (A, B, C) in the electric circuit, at a place along the phase conductors upstream of the place chosen for identification, and in identifying the phase conductors by a receiving means coupled to the phase conductors taken in pairs at the place chosen for identification.

16. A method as claimed in claim 15, in which the electric circuit comprises a three-phase cable (A, B, C).

17. A method as claimed in claim 15, in which the electric circuit comprises a set of three unipolar cables (A, B, C).

18. A method as claimed in claim 15, in which one of the audio signals is intermittent and the other is continuous.

19. A method as claimed in claim 15, in which the two independent generators (10, 11) of different audio signals have rechargeable batteries.

20. A method as claimed in claim 15, in which the two independent generators (10, 11) of different audio signals have the appearance of clip-on probes.

21. A method as claimed in claim 15, in which the means for receiving different audio signals is an ordinary pair of earphones (12).

22. A method as claimed in claim 15, in which the means of receiving different audio signals is a public address amplifier (12).

23. A method as claimed in claim 15, in which the phase conductors at the place chosen for identification are bare conductors.

24. A method as claimed in claim 15, in which the phase conductors at the place chosen for identification are insulated conductors.

25. A method as claimed in claim 15 or 23, in which the receiving means (28, 29) is connected by direct electric coupling to the phase conductors at the place chosen for identification.

26. A method as claimed in claims 15 or 24, in which the reception means is connected to the phase conductors at the place chosen for identification, by electromagnetic coupling via receiver clips (28, 29).

27. A method as claimed in claim 15, in which the place chosen for identification is situated in a manhole (21) near the insulated connections (25, 26, 27) of the phase conductors in the given electric circuit.

28. A method as claimed in claim 15, in which the place chosen for identification is situated at the terminals (34) of the phase conductors in the given electric circuit.

29. A method as claimed in claim 17 or 27, in which earths (21, 22) on each phase conductor (A, B, C) of a given electric circuit are installed at each end of the circuit and in which the means (28, 29) for receiving the different audio signals is connected to the phase conductors taken in pairs at the place chosen for identification, by electromagnetic coupling by receiving clamps (28, 29) placed on the aforementioned two phase conductors in the given electric circuit near the insulated connections 25, 26, 27) and above the armoured covering (15, 16) around the two conductors.

## Patentansprüche

1. System zur Phasenidentifizierung von drei elektrischen Phasenleitern (A, B, C), die mit einer Abschirmung (15, 16) versehen, in einer elektrischen Leitung isoliert und miteinander mit oder ohne Erdung (22) an einer Stelle (32, 33) verbunden sind, die von der für die Phasenidentifizierung gewählten Stelle entfernt ist, gekennzeichnet durch zwei unabhängige Generatoren (10, 11) von Audiodifferenzsignalen, welche jeweils durch elektromagnetische Kopplung und ohne direkten Kontakt mit zwei der Phasenleiter (A, B, C) verbunden sind, wobei jeder eine bereits identifizierte Phase an einer längs der Phasenleiter zugänglichen, oberhalb von der für die Phasenidentifizierung gewählten Stelle und eine Empfangseinrichtung zum Empfangen der Audiodifferenzsignale durch zwei Empfangsklemmen (28, 29) hat, welche an der für die Identifizierung gewählten Stelle mit jeweils zwei Phasenleitern verbunden sind und Audiosignale erzeugen, um die Phase der Phasenleiter zu identifizieren.

2. System nach Anspruch 1, bei dem die elektrische Leitung durch ein Drehstromkabel (A, B, C) gebildet wird.

3. System nach Anspruch 1, bei dem die elektrische Leitung durch insgesamt drei Einleiterkabel (A, B, C) gebildet wird.

4. System nach Anspruch 1, bei dem eines der Audiosignale intermittierend und das andere ein Dauersignal ist.

5. System nach Anspruch 1, bei dem die beiden unabhängigen Generatoren (10, 11) von Audiodifferenzsignalen wiederaufladbare Batterien haben.

6. System nach Anspruch 1, bei dem die beiden unabhängigen Generatoren (10, 11) von Audiodifferenzsignalen als Meßklemmen ausgebildet sind.

7. System nach Anspruch 1, bei dem die Empfangseinrichtung der Audiodifferenzsignale ein einfaches Paar von Kopfhörern (12) ist.

8. System nach Anspruch 1, bei dem die Empfangseinrichtung der Audiodifferenzsignale ein Lautsprecherverstärker (12) ist.

9. System nach Anspruch 1, bei dem die Phasenleiter an der für die Identifizierung gewählten Stelle abisolierte Leiter sind.

10. System nach Anspruch 1, bei dem die Phasenleiter an der für die Identifizierung gewählten Stelle isolierte Leiter sind.

11. System nach Anspruch 1 oder 9, bei dem die Empfangseinrichtung (28, 29) an der für die Identifizierung gewählten Stelle durch direkte elektrische Kopplung mit den Phasenleitern verbunden ist.

12. System nach Anspruch 1 oder 10, bei dem die Empfangseinrichtung an der für die Identifizierung gewählten Stelle durch elektromagnetische Kopplung über Empfangsklemmen (28, 29) mit den Phasenleitern verbunden ist.

13. System nach Anspruch 1, bei dem die für die Identifizierung gewählte Stelle in einem Zugangsschacht (21) in der Nähe der isolierten Verbindungen (25, 26, 27) der Phasenleiter der elektrischen Leitung angeordnet ist.

14. System nach Anspruch 1, bei dem die für die Identifizierung gewählte Stelle an den Endpunkten (34) der Phasenleiter der elektrischen Leitung angeordnet ist.

15. Verfahren zur Phasenidentifizierung von drei elektrischen Phasenleitern (A, B, C) mit einer Abschirmung (15, 16) um einen leitenden Kern (13), die in einer elektrischen Leitung isoliert und miteinander mit oder ohne Erdung (22) an einer Stelle verbunden sind, die von der für die Identifizierung gewählten Stelle entfernt ist, dadurch gekennzeichnet, daß zwei unabhängige Generatoren (10, 11) von Audiodifferenzsignalen eingesetzt werden, die durch elektromagnetische Kopplung und ohne direkten Kontakt mit dem leitenden Kern an zwei zuvor identifizierten Phasenleitern (A, B, C) der elektrischen Leitung, an einer Stelle längs der Phasenleiter, oberhalb von der für die Phasenidentifizierung gewählten Stelle verbunden sind, und die Phasenleiter mit Hilfe einer Empfangseinrichtung identifiziert werden, die an der für die Identifizierung gewählten Stelle an jeweils zwei Phasenleiter angekoppelt ist.

16. Verfahren nach Anspruch 15, bei dem die elektrische Leitung von einem Drehstromkabel (A, B, C) gebildet wird.

17. Verfahren nach Anspruch 15, bei dem die elektrische Leitung durch insgesamt drei Einleiterkabel (A, B, C) gebildet wird.

18. System nach Anspruch 15, bei dem eines der Audiosignale intermittierend und das andere ein Dauersignal ist.

19. Verfahren nach Anspruch 15, bei dem die beiden unabhängigen Generatoren (10, 11) von Audiodifferenzsignalen aufladbare Batterien haben.

20. Verfahren nach Anspruch 15, bei dem die beiden unabhängigen Generatoren (10, 11) von Audiodifferenzsignalen als Meßklemmen ausgebildet sind.

21. Verfahren nach Anspruch 15, bei dem die Empfangseinrichtung der Audiodifferenzsignale ein einfaches Paar von Kopfhörern (12) ist.

22. Verfahren nach Anspruch 15, bei dem die Empfangseinrichtung der Audiodifferenzsignale ein Lautsprecherverstärker (12) ist.

23. Verfahren nach Anspruch 15, bei dem die Phasenleiter an der für die Identifizierung gewählten Stelle abisolierte Leiter sind.

24. Verfahren nach Anspruch 15, bei dem die Phasenleiter an der für die Identifizierung gewählten Stelle isolierte Leiter sind.

25. Verfahren nach Anspruch 15 oder 23, bei dem die Empfangseinrichtung (28, 29) an der für die Identifizierung gewählten Stelle durch direkte elektrische Kopplung mit den Phasenleitern verbunden ist.

26. Verfahren nach Anspruch 15 oder 24, bei dem die Empfangseinrichtung an der für die Identifizierung gewählten Stelle durch elektromagnetische Kopplung über Empfangsklemmen (28, 29) mit den Phasenleitern verbunden ist.

27. Verfahren nach Anspruch 15, bei dem die für die Identifizierung gewählte Stelle in einem Zugangsschacht (21) in der Nähe der isolierten Verbindungen (25, 26, 27) der Phasenleiter der elektrischen Leitung angeordnet ist.

28. Verfahren nach Anspruch 15, bei dem die für die Identifizierung gewählte Stelle an den Endpunkten (34) der Phasenleiter der elektrischen Leitung angeordnet ist.

29. Verfahren nach Anspruch 17 oder 27, bei dem Erdungen (21, 22) an jedem der Phasenleiter (A, B, C), an jedem Ende einer elektrischen Leitung installiert werden, und bei dem die Empfangseinrichtung (28, 29) der Audiodifferenzsignale mit jeweils zwei Phasenleitern an der für die Identifizierung gewählten Stelle durch elektromagnetische Kupplung mit Hilfe von Empfangsklemmen (28, 29), die an den beiden Phasenleitern der elektrischen Leitung in der Nähe der isolierten Verbindungen (25, 26, 27) und auf der Abschirmung (15, 16) der beiden Leiter angeordnet sind, verbunden wird.
